# FASCICULE DE BREVET EUROPEEN

(11) **EP 2 399 088 B1**
(45) Date de publication et mention de la délivrance du brevet: **21.12.2016**
(21) Numéro de dépôt: 10708237.2
(22) Date de dépôt: 15.02.2010
(51) Int. Cl.: F25B 21/00

(54) **GENERATEUR THERMIQUE MAGNETOCALORIQUE**
MAGNETOKALORISCHER WÄRMEERZEUGER
MAGNETOCALORIC HEAT GENERATOR

(30) Priorité: 17.02.2009 FR 0951019
(43) Date de publication de la demande: 28.12.2011
(73) Titulaire: Cooltech Applications S.A.S., 67810 Holtzheim (FR)
(72) Inventeur: HEITZLER, Jean-Claude, F-68180 Horbourg Wihr (FR); MULLER, Christian, F-67000 Strasbourg (FR)
(74) Mandataire: Koelbel, Caroline
(86) Numéro de dépôt international: PCT/FR2010/000127
(87) Numéro de publication internationale: WO 2010/094855

(56) Documents cités:
- EP-A- 1 818 628
- DE-B- 1 272 467
- US-A1- 2007 220 901
- "FRIDGE OF THE FUTURE" MECHANICAL ENGINEERING, ASME. NEW YORK, US, vol. 116, no. 12, 1 décembre 1994 (1994-12-01), pages 76-80, XP000486088 ISSN: 0025-6501

## Description

### Domaine technique :

La présente invention concerne un générateur thermique magnétocalorique comprenant au moins un élément magnétocalorique comportant une première extrémité et une seconde extrémité, un arrangement magnétique destiné à soumettre chaque élément magnétocalorique à un champ magnétique variable, créant alternativement, dans chaque élément magnétocalorique un cycle d'échauffement et un cycle de refroidissement, un moyen d'entraînement d'un fluide caloporteur à travers ledit élément magnétocalorique alternativement en direction de la première extrémité et de la seconde extrémité et inversement, de manière synchronisée avec la variation du champ magnétique, et au moins un moyen d'échange de l'énergie thermique produite par ledit élément magnétocalorique avec un dispositif extérieur audit élément magnétocalorique, ledit moyen d'échange étant intégré dans le générateur thermique de manière à être traversé dans un sens par le fluide caloporteur entrant dans l'élément magnétocalorique au niveau d'une des extrémités pendant un cycle d'échauffement ou de refroidissement et traversé dans le sens opposé par le fluide caloporteur sortant de l'élément magnétocalorique au niveau de la même extrémité pendant l'autre cycle de refroidissement ou d'échauffement, ledit moyen d'échange étant juxtaposé à au moins une des extrémités de l'élément magnétocalorique et disposé au moins entre un moyen d'entraînement du fluide caloporteur et une des extrémités dudit élément magnétocalorique.

### Technique antérieure :

La technologie du froid magnétique est connue depuis plus d'une vingtaine d'années et on sait les avantages qu'elle apporte en termes d'écologie et de développement durable. On connaît également ses limites quant à sa puissance calorifique utile et à son rendement. Dès lors, les recherches menées dans ce domaine tendent toutes à améliorer les performances d'un tel générateur, en jouant sur les différents paramètres, tels que la puissance d'aimantation, les performances de l'élément magnétocalorique, la surface d'échange entre le fluide caloporteur et les éléments magnétocaloriques, les performances des échangeurs de chaleur, etc.

Les échangeurs de chaleur ont pour objet de restituer ou d'échanger avec une ou plusieurs applications extérieures audit générateur thermique l'énergie thermique réalisée par ledit générateur thermique. Ces applications extérieures peuvent être l'air environnant le générateur thermique, un dispositif ou une enceinte thermique, par exemple.

Les générateurs thermiques magnétocaloriques connus sont constitués par des éléments magnétocaloriques traversés alternativement de part en part par un fluide caloporteur.

Dans une première configuration connue, ce fluide caloporteur est mis en circulation alternative entre une première cellule en communication avec la première extrémité des éléments magnétocaloriques et une seconde cellule en communication avec la seconde extrémité des éléments magnétocaloriques, et un échangeur thermique est relié thermiquement à chacune desdites cellules.

Dans une seconde configuration, chaque cellule est reliée fluidiquement à un échangeur de chaleur intégré dans une boucle hydraulique.

Ces configurations existantes ne sont toutefois pas totalement satisfaisantes. En effet, dans les deux cas, une part de l'énergie thermique est perdue entre la sortie des modules thermiques et les échangeurs de chaleur pendant les échanges thermiques, du fait notamment des résistances et fuites thermiques dans les échangeurs.

La publication EP 1 818 628 décrit un générateur magnétocalorique, comprenant un élément magnétocalorique comportant une première extrémité et une seconde extrémité, un arrangement magnétique destiné à soumettre l'élément magnétocalorique à un champ magnétique variable, créant alternativement, dans l'élément magnétocalorique un cycle d'échauffement et un cycle de refroidissement, un moyen d'entraînement d'un fluide caloporteur à travers ledit élément magnétocalorique alternativement en direction de la première extrémité et de la seconde extrémité et inversement, de manière synchronisée avec la variation du champ magnétique, et au moins un moyen d'échange de l'énergie thermique produite par ledit élément magnétocalorique avec un dispositif extérieur, ledit moyen d'échange étant intégré dans le générateur thermique de manière à être traversé dans un sens par le fluide caloporteur entrant dans ledit élément magnétocalorique au niveau d'une des extrémités pendant un cycle d'échauffement ou de refroidissement, et traversé dans le sens opposé par le fluide caloporteur sortant dudit élément magnétocalorique au niveau de la même extrémité pendant l'autre cycle de refroidissement ou d'échauffement, ledit moyen d'échange étant juxtaposé à au moins une des extrémités dudit élément magnétocalorique et disposé au moins entre cette extrémité et ledit moyen d'entraînement du fluide caloporteur.

La publication technique « Fridge of the future » (Mechanical Engineering, Asme. New York, US, vol.116, no.12, 1er décembre 1994, pages 76-80, XP000486088-ISSN : 0025-6501-page 3) décrit également un système de réfrigération dans lequel les échangeurs thermiques semblent raccordés directement aux extrémités froide et chaude de l'élément thermique. Néanmoins, ces publications sont muettes sur les moyens d'échange thermiques avec un ou plusieurs circuits extérieurs.

### Exposé de l'invention:

La présente invention vise à pallier ces inconvénients en proposant une solution industrielle aux problèmes évoqués ci-dessus. A cet effet, le générateur thermique magnétocalorique selon l'invention est réalisé de telle sorte que le transfert d'énergie thermique entre le générateur thermique et la ou les applications extérieures est optimisé pour réduire au maximum les pertes thermiques.

Dans ce but, l'invention concerne un générateur thermique magnétocalorique ayant les caractéristiques de la revendication 1.

Ledit conduit peut être de forme cylindrique, éventuellement rectangulaire, ou peut également être constitué par des pores formés dans ledit moyen d'échange. Il peut aussi être défini par des rainures.

Ledit générateur thermique peut notamment comporter au moins deux circuits parcourus alternativement à contre-courant par le fluide extérieur dudit dispositif extérieur.

En variante, ledit moyen d'échange peut comporter des ailettes sur sa périphérie pour échanger avec le milieu extérieur.

Enfin, ledit élément magnétocalorique peut comporter au moins deux matériaux magnétocaloriques disposés de manière consécutive et formant au moins deux étages thermiques consécutifs, reliés fluidiquement par un moyen d'entraînement du fluide caloporteur commun.

Dans une telle configuration, deux matériaux adjacents peuvent être soumis, deux-à-deux, soit au même cycle d'échauffement ou de refroidissement, soit à un cycle différent d'échauffement et de refroidissement. Dans le premier cas deux matériaux adjacents sont traversés à chaque cycle dans le même sens par le fluide caloporteur et dans le second cas, ils sont traversés dans un sens de circulation opposé.

En outre, afin de minimiser les pertes thermiques, ledit moyen d'échange peut être recouvert par une couche de matériau thermiquement isolant.

### Description sommaire des dessins :

La présente invention et ses avantages apparaîtront mieux dans la description suivante de plusieurs modes de réalisation donnés à titre d'exemples non limitatifs, en référence aux dessins annexés, dans lesquels:
- les figures 1A et 1B sont des vues schématiques d'un générateur thermique selon l'invention,
- la figure 1C est une vue agrandie du détail A de la figure 1A,
- la figure 2 est une vue en perspective éclatée du générateur thermique représenté dans les figures 1A et 1B,
- la figure 3A est une vue de face d'un moyen d'échange du générateur thermique de la figure 2 selon une autre forme de réalisation,
- la figure 3B est une vue agrandie du détail B de la figure 3A, et
- les figures 4A et 4B sont des vues similaires à celles des figures 1A et 1B représentant un générateur thermique selon une variante de réalisation.

### Illustrations de l'invention :

Dans les exemples de réalisation illustrés, les pièces ou parties identiques portent les mêmes références numériques.

Les générateurs thermiques 10, 20, 30 comportent plusieurs éléments magnétocaloriques 2. Bien que les éléments magnétocaloriques 2 représentés comportent un seul matériau magnétocalorique, l'invention n'est pas limitée à ce nombre. En effet un élément magnétocalorique 2 peut comporter plusieurs matériaux magnétocaloriques ayant une température de Curie différente et produisant un effet magnétocalorique important, de sorte que leur juxtaposition permet de réaliser un gradient de température élevé entre l'extrémité 3 et l'extrémité 4 de l'élément magnétocalorique 2 et donc d'obtenir un rendement encore plus important dans le générateur thermique 10, 20, 30. Une telle configuration permet également de couvrir une large gamme de températures qui pourra correspondre à la gamme de fonctionnement ou d'utilisation.

Chaque élément magnétocalorique 2 comporte deux extrémités opposées, une première extrémité 3 par exemple froide, et une seconde extrémité 4 par exemple chaude. Un fluide caloporteur est mis en circulation à travers cet élément magnétocalorique 2 en direction de l'une ou l'autre des extrémités 3 et 4 et en relation avec la variation dudit champ magnétique de manière à réaliser et à maintenir un gradient de température entre les deux extrémités opposées 3 et 4 de cet élément magnétocalorique 2.

Ces extrémités 3, 4 sont reliées fluidiquement chacune à une cellule 13, 14 contenant le fluide caloporteur et dans laquelle peut être intégré le moyen d'entraînement du fluide caloporteur lorsqu'il se présente sous la forme d'un piston 7, comme dans les exemples de réalisation illustrés. Bien entendu, l'invention n'est pas limitée à ce type de moyen d'entraînement du fluide caloporteur et tout autre moyen analogue, telle qu'une pompe ou similaire, peut être prévu.

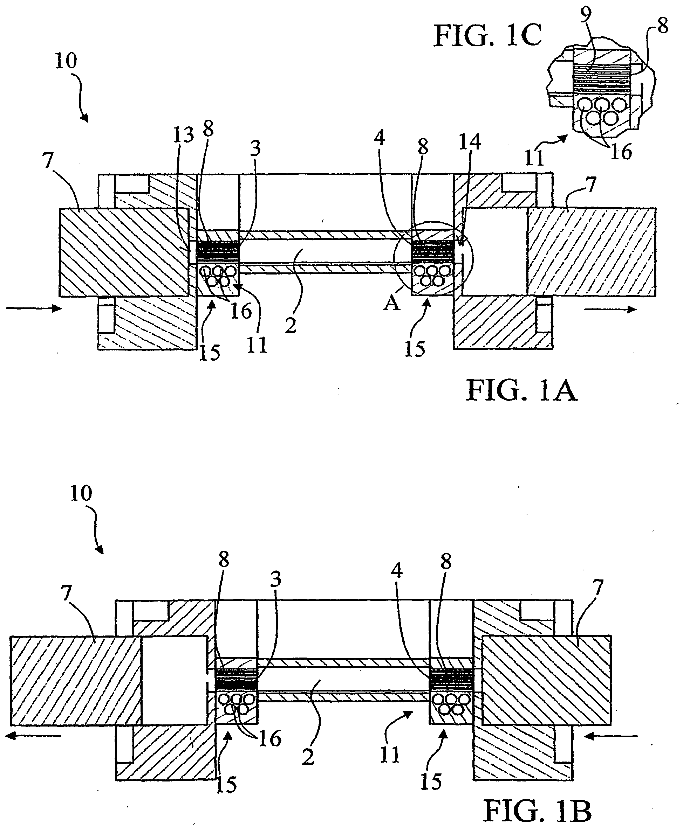

Dans les générateurs thermiques 10 et 20 représentés, en particulier dans celui des figures 1A et 1B, le fluide caloporteur circule à travers ledit élément magnétocalorique 2 en direction de la seconde extrémité 4 - qui peut être considérée comme l'extrémité chaude - lors du cycle d'échauffement (cf. figure 1A) et en direction de la première extrémité 3 - qui peut être considérée comme l'extrémité froide - lors du cycle de refroidissement (cf. figure 1B). Un gradient de température est ainsi créé dans l'élément magnétocalorique 2 entre ses deux extrémités 3 et 4.

Afin de faciliter les échanges thermiques avec le fluide caloporteur, les matériaux magnétocaloriques constituant les éléments magnétocaloriques 2 peuvent être poreux de sorte que leurs pores forment des passages de fluide débouchants. Ils peuvent également se présenter sous la forme d'un bloc plein dans lequel des minis ou micro-canaux sont usinés ou encore être constitués par un assemblage de plaques, éventuellement rainurées, superposées et entre lesquelles le fluide caloporteur peut s'écouler. Ils peuvent aussi se présenter sous la forme de poudre ou de particules de sorte que les interstices forment des passages de fluide. Toute autre forme de réalisation permettant au fluide caloporteur de traverser lesdits matériaux magnétocaloriques peut bien entendu convenir.

L'arrangement magnétique (non représenté) peut être constitué par un assemblage d'aimants permanents en mouvement relatif par rapport à chaque élément magnétocalorique 2, par un électroaimant alimenté séquentiellement ou par tout autre moyen analogue susceptible de créer une variation de champ magnétique.

Les figures 1A et 1B représentent un générateur magnétocalorique 10 comportant deux échangeurs de chaleur ou moyens d'échange 15 identiques montés chacun entre une extrémité 3, 4 de l'élément magnétocalorique 2 et la chambre d'un piston 7. Ce piston 7 forme le moyen de manoeuvre ou d'entraînement du fluide caloporteur. Les moyens d'échange 15 comportent chacun une zone de transfert thermique 8, réalisée en une matière thermiquement conductrice ou non, munie de passages traversants 9 pour le fluide caloporteur (cf. figure 1C). Chaque zone de transfert 8 est contigüe à une extrémité 3, 4 de l'élément magnétocalorique 2 et est ainsi traversée par le fluide caloporteur lorsqu'il entre dans l'élément magnétocalorique 2 et lorsqu'il en sort. Une telle configuration permet avantageusement de réaliser deux échanges thermiques avec le fluide caloporteur, lors des allers-retours successifs de ce dernier à travers l'élément magnétocalorique 2 correspondant, c'est-à-dire de doubler les échanges thermiques. Cela est particulièrement avantageux lorsque les cycles d'activation et de désactivation magnétique sont de courte durée, et que le fluide caloporteur circule à une vitesse élevée. Cette configuration permet d'assurer que le maximum d'énergie thermique est échangé avant que le fluide caloporteur ne soit réintégré dans l'élément magnétocalorique 2. La récupération de l'énergie thermique générée par le générateur thermique 1 est ainsi optimisée et s'opère sur la totalité du temps de cycle.

En se référant plus particulièrement à la figure 1A, dans laquelle l'élément magnétocalorique 2 est soumis à un champ magnétique et le fluide caloporteur circule de la première extrémité 3 (extrémité froide) vers la seconde extrémité 4 (extrémité chaude), de la gauche vers la droite selon le sens des flèches, on constate; d'une part, que le fluide caloporteur traverse la zone de transfert 8 du moyen d'échange 5 situé du côté de la première extrémité 3 avant de traverser l'élément magnétocalorique 2 et, d'autre part, traverse la zone de transfert 8 du moyen d'échange 5 situé du côté de la seconde extrémité 4 à sa sortie de l'élément magnétocalorique 2 lorsqu'il a été réchauffé par son passage à travers l'élément magnétocalorique 2 soumis à un champ magnétique.

En se référant à présent à la figure 1B, dans laquelle l'élément magnétocalorique 2 est en-dehors du champ magnétique et se refroidit, le fluide caloporteur circule de la seconde extrémité 4 vers la première extrémité 3 (de la droite vers la gauche selon le sens des flèches), on constate, d'une part, que le fluide caloporteur traverse à nouveau la zone de transfert 8 du moyen d'échange 5 situé du côté de la seconde extrémité 4 avant de traverser l'élément magnétocalorique 2 et, d'autre part, traverse la zone de transfert 8 du moyen d'échange 5 situé du côté de la première extrémité 3 à sa sortie de l'élément magnétocalorique 2 lorsqu'il a été refroidi par son passage à travers l'élément magnétocalorique 2 situé en-dehors du champ magnétique.

Ainsi, le maximum d'énergie thermique peut être récupéré ou échangé au niveau de chaque extrémité 3 et 4 de l'élément magnétocalorique 2 du générateur thermique 10 selon l'invention. Cela est, bien entendu, valable pour l'ensemble des générateurs thermiques 10, 20, 30 illustrés. La zone de transfert 8, et plus précisément les passages traversants 9 de cette dernière sont, bien entendu, réalisés et conçus de telle sorte que leur intégration dans la cellule 13, 14 concernée n'entraîne pas d'augmentation sensible des pertes de charge du fluide caloporteur. A cet effet, les passages traversants 9 de ladite zone de transfert 8 peuvent présenter, le cas échéant, une configuration identique aux passages ou canaux de fluide dans l'élément magnétocalorique 2 et alignés avec ces derniers.

Le moyen d'échange 15 est conçu pour transférer l'énergie thermique échangée dans la zone de transfert 8 en direction d'un dispositif ou d'une application extérieur(e). A cet effet, le moyen d'échange 15 comporte un circuit 11 pour la circulation d'un fluide extérieur dédié à un dispositif ou une application extérieur(e). Le moyen d'échange 15 comporte d'une part, en plus des passages traversants 9 pour le fluide caloporteur, des conduits 16 formant le circuit 11 pour le passage du fluide extérieur. Le circuit 11 représenté comporte cinq conduits 16. Le sens de circulation du fluide dans ces conduits 16 peut être le même, mais est de préférence différent d'un conduit à l'autre pour réaliser un échange uniforme dans l'ensemble du moyen d'échange 15 concerné (circulation à contre-courant).

L'invention n'est, bien entendu, pas limitée à ce type de configuration avec un circuit 11 de fluide pour l'application ou un dispositif extérieur(e). Le moyen d'échange 15 peut, à titre d'exemple, comporter des ailettes de toute forme ou dimension sur son pourtour extérieur. En outre, dans le cas d'un circuit 11 de fluide extérieur intégré dans ledit moyen d'échange 15, comme dans le générateur thermique 10 illustré, ledit circuit 11 peut, en variante, comprendre des conduits 16 complémentaires situés de part et d'autre de la zone de transfert 8.

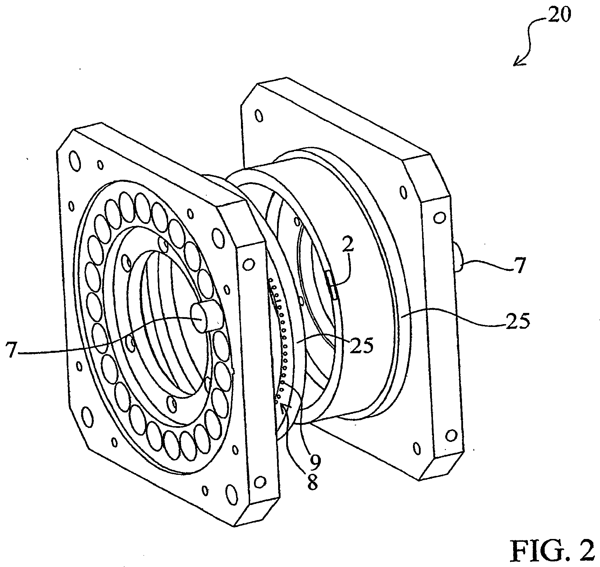

La figure 2 illustre un générateur thermique 20 réalisé selon le principe du générateur thermique 10 décrit dans les figures 1A et 1B. Ce générateur thermique 20 présente une structure circulaire comportant des éléments magnétocaloriques 2 adjacents et disposés en anneau circulaire. Les deux moyens d'échange 25 se présentent chacun sous la forme d'un anneau circulaire, réalisé en une matière thermiquement conductrice ou non, et comportant, d'une part, des passages traversants 9 permettant au fluide caloporteur de se déplacer à travers les éléments magnétocaloriques 2 sous l'action des pistons 7 et, d'autre part, un circuit pour la circulation d'un fluide extérieur. Ce circuit n'est pas visible sur la figure 2. De même, les moyens de raccordement de ce circuit tels que des embouts ou moyens analogues ne sont pas non plus illustrés sur cette figure. L'avantage d'un tel générateur thermique 20 consiste en sa compacité.

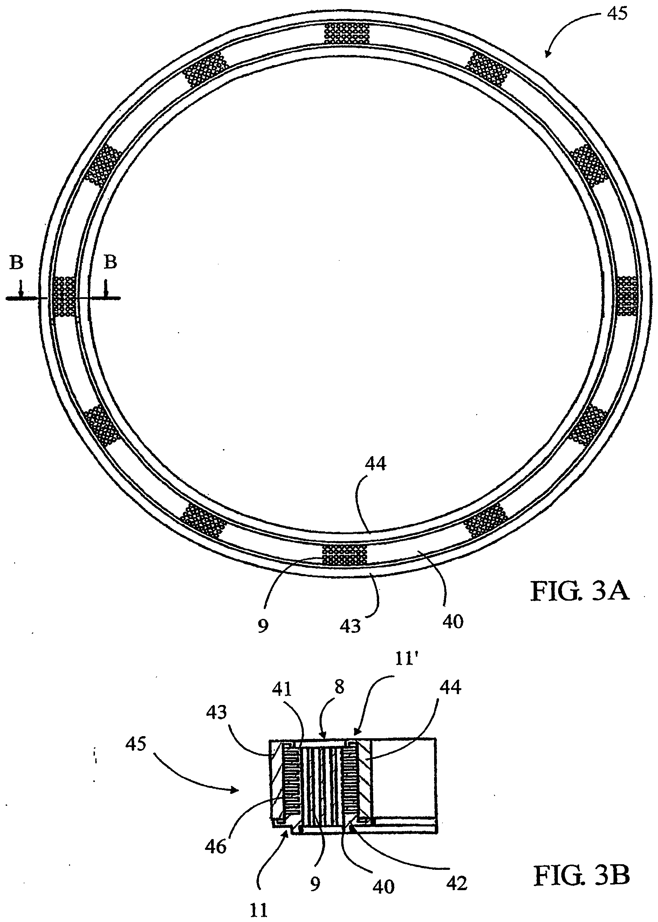

La figure 3A représente un exemple de réalisation industrielle d'un moyen d'échange 45 sous la forme d'un anneau circulaire pouvant entrer dans la construction du générateur thermique 20 de la figure 2. Il comporte une bague 40 pourvue de passages traversants 9 pour le fluide caloporteur, formés par exemple de perforations orientées axialement et disposés en correspondance d'un côté de chaque élément magnétocalorique 2 et de l'autre côté de chaque piston 7 sans perte de charge. Les parois externe 41 et interne 42 de cette bague 40 comportent des rainures 46, orientées radialement et fermées respectivement par un anneau externe 43 et un anneau interne 44 pour former les conduits d'un circuit interne 11' et d'un circuit externe 11 dans lesquels circule un fluide extérieur transférant par un échange fluide/fluide l'énergie thermique produite par le générateur 20. Les anneaux 43 et 44 sont assemblés à la bague 40 par tout procédé approprié permettant d'obtenir un assemblage étanche, tel que par bridage, sertissage, coulage, soudage, etc. Ce mode de construction a l'avantage d'être facilement industrialisable à moindre coût et de créer des circuits 11, 11' pour la circulation d'un fluide extérieur offrant une très grande surface d'échange thermique et permettant un flux laminaire plus constant. De plus, la réalisation de deux circuits 11, 11' parallèles, disposés de part et d'autre du moyen d'échange 45 avec l'élément magnétocalorique 2, permet le transfert thermique de manière homogène quand plusieurs éléments magnétocaloriques 2 sont juxtaposés. Cette homogénéisation de la température est obtenue et améliorée en faisant circuler le fluide dans le circuit interne 11' en sens opposé au fluide circulant dans le circuit externe 11. On peut encore améliorer l'efficacité de l'échange thermique en divisant les circuits 11 et 11' en plusieurs secteurs raccordés en parallèle.

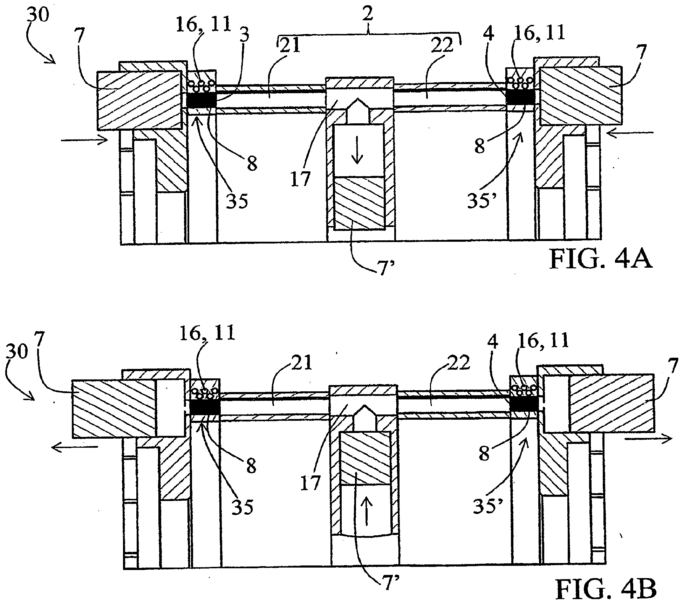

Les figures 4A et 4B représentent une variante de réalisation d'un générateur thermique 30 comportant un élément magnétocalorique 2 constitué par deux matériaux magnétocaloriques 21 et 22. Ces matériaux magnétocaloriques 21 et 22 sont constamment dans un état magnétique opposé, c'est-à-dire lorsque l'un 21 desdits matériaux magnétocaloriques est soumis à un champ magnétique, l'autre matériau magnétocalorique 22 est hors du champ magnétique, et inversement. Dans cette variante de réalisation, les première et seconde extrémités 3 et 4 sont matérialisées chacune par une extrémité de chacun des matériaux magnétocaloriques 21,22. Un moyen d'échange 35, 35' identique aux moyens d'échange 15 montés dans le générateur 10 des figures 1A et 1B est monté de manière adjacente à chacune desdites extrémités 3 et 4. Le fluide caloporteur est mis en circulation à travers lesdits matériaux magnétocaloriques 21, 22 par trois moyens d'entraînement 7, 7', à savoir deux pistons 7 situés chacun à une extrémité dudit élément magnétocalorique 2 et un piston 7' dont la chambre est reliée à une cellule 17 commune aux deux matériau 21 et 22 et les reliant fluidiquement entre eux.

En référence à la figure 4A, représentant l'un de deux cycles de fonctionnement du générateur thermique 30, le matériau magnétocalorique 21 situé à gauche sur la figure est magnétiquement activé et le matériau magnétocalorique 22 situé à droite sur la figure est magnétiquement désactivé. Le fluide caloporteur circule de la gauche vers la droite dans le matériau magnétocalorique 21 situé à gauche et de la droite vers la gauche dans le matériau magnétocalorique 22 de droite, en direction de la cellule 17 commune. Le fluide caloporteur traverse ainsi, de manière simultanée, d'une part, la zone de transfert 8 du moyen d'échange 35 situé du côté de la première extrémité 3, ce qui permet d'échanger l'énergie thermique avec le fluide caloporteur avant sa réintégration dans le matériau magnétocalorique 21 situé à gauche et, d'autre part, la zone de transfert 8 du moyen d'échange 35' situé du côté de la seconde extrémité 4, ce qui permet d'échanger l'énergie thermique avec le fluide caloporteur avant sa réintégration dans le matériau magnétocalorique 22 situé à droite.

Dans le second cycle, le matériau magnétocalorique 21 situé à gauche sur la figure est magnétiquement désactivé et le matériau magnétocalorique 22 situé à droite sur la figure est magnétiquement activé. Le fluide caloporteur sort de la cellule 17 commune et circule de la droite vers la gauche dans le matériau magnétocalorique 21 situé à gauche et de la gauche vers la droite dans le matériau magnétocalorique 22 de droite. Le fluide caloporteur traverse ainsi, à nouveau, de manière simultanée, d'une part, le matériau magnétocalorique 21 situé à gauche tout en se refroidissant et également la zone de transfert 8 du moyen d'échange 35 situé du côté de la première extrémité 3, et, d'autre part, le matériau magnétocalorique 22 situé à droite tout en s'échauffant et également la zone de transfert 8 du moyen d'échange 35' situé du côté de la seconde extrémité 4.

Dans cette configuration également, chaque cycle magnétique ou cycle d'échauffement et de refroidissement est exploité, de sorte que le maximum d'énergie thermique peut être récupéré ou échangé au niveau de chaque extrémité 3 et 4 de l'élément magnétocalorique 2 du générateur thermique 30.

Bien que cela ne soit pas illustré, il peut également être prévu d'utiliser un moyen d'échange tel que celui décrit dans la présente description pour relier thermiquement entre eux soit deux générateurs thermiques, soit deux éléments magnétocaloriques adjacents, formant deux étages thermiques consécutifs d'un même générateur thermique.

Dans l'ensemble des générateurs thermiques 10, 20, 30 représentés, le moyen d'échange 15, 25, 35, 35', 45 est intégré à l'intérieur desdits générateurs et disposé de manière contigüe à chaque extrémité 3, 4 du ou des éléments magnétocalorique 2. L'invention n'est toutefois pas limitée à ce type de configuration et prévoit également que toutes les extrémités 3, 4 ne soient pas en relation avec un tel moyen d'échange 15, 25, 35, 35', 45 et que seule l'une des extrémités 3 et 4 le soit.

### Possibilités d'application industrielle :

Il ressort clairement de cette description que l'invention permet d'atteindre les buts fixés, à savoir proposer un générateur thermique 10, 20, 30 de construction simple dans lequel le transfert de l'énergie thermique produite par les éléments magnétocaloriques 2 est simplifié et réalisé de manière efficace avec un minimum de pertes.

Le fait d'intégrer un moyen d'échange 15, 25, 35, 35, 45 dans le générateur thermique selon l'invention, de sorte qu'il est en contact à la fois avec le fluide entrant dans et sortant de l'élément magnétocalorique concerné permet d'extraire directement et de manière efficace l'énergie thermique du fluide caloporteur produite dans ledit élément magnétocalorique. Il est à préciser que le même fluide caloporteur entre et sort du même élément magnétocalorique, mais avec une température différente suite à l'échange thermique entre ledit fluide caloporteur et le moyen d'échange thermique 15, 25, 35, 35', 45.

La non utilisation, au démarrage du générateur thermique, du ou des circuits d'échange formés par le ou les canaux 11, 11' permet d'établir plus rapidement le gradient de température entre l'extrémité chaude 4 et l'extrémité froide 3 de l'élément magnétocalorique 2. Cette faculté permet de diminuer le temps de fonctionnement du générateur thermique et, de fait, sa consommation énergétique. Le rendement thermique dudit générateur est par conséquent amélioré.

Un tel générateur thermique 10, 20, 30 peut trouver une application aussi bien industrielle que domestique dans le domaine du chauffage, de la climatisation, du tempérage, refroidissement ou autres, ce, à des coûts compétitifs, pour un faible encombrement.

La présente invention n'est pas limitée aux exemples de réalisation décrits mais s'étend à toute modification et variante évidentes pour un homme du métier tout en restant dans l'étendue de la protection définie dans les revendications annexées.

## Revendications

1. Générateur thermique magnétocalorique, comprenant plusieurs éléments magnétocaloriques (2) comportant chacun une première extrémité (3) et une seconde extrémité (4), un arrangement magnétique destiné à soumettre chaque élément magnétocalorique (2) à un champ magnétique variable, créant alternativement, dans chaque élément magnétocalorique (2) un cycle d'échauffement et un cycle de refroidissement, un moyen d'entraînement d'un fluide caloporteur à travers lesdits éléments magnétocaloriques (2) alternativement en direction de la première extrémité (3) et de la seconde extrémité (4) et inversement, de manière synchronisée avec la variation du champ magnétique, et au moins un moyen d'échange (15, 25, 35, 35', 45) de l'énergie thermique produite par lesdits éléments magnétocaloriques (2) avec un dispositif extérieur, ledit moyen d'échange étant intégré dans ledit générateur thermique de manière à être traversé dans un sens par le fluide caloporteur entrant dans lesdits éléments magnétocaloriques (2) au niveau d'une des extrémités (3, 4) pendant un cycle d'échauffement ou de refroidissement, et traversé dans le sens opposé par le fluide caloporteur sortant desdits éléments magnétocaloriques (2) au niveau de la même extrémité (3, 4) pendant l'autre cycle de refroidissement ou d'échauffement, ledit moyen d'échange étant juxtaposé à au moins une des extrémités (3, 4) desdits éléments magnétocaloriques (2) et disposé au moins entre cette extrémité et ledit moyen d'entraînement (7) du fluide caloporteur, ledit générateur présentant une structure circulaire dans laquelle lesdits éléments magnétocaloriques sont disposés en anneau circulaire, et ledit moyen d'échange (15, 25, 35, 35', 45) se présentant sous la forme d'un anneau circulaire et comportant plusieurs zones de transfert thermique (8) disposées chacune en correspondance d'un des éléments magnétocaloriques (2), chaque zone de transfert thermique étant munie de passages traversants (9) pour le fluide caloporteur et d'au moins un circuit (11) formé par au moins un conduit (16, 46) pour un fluide extérieur appartenant audit dispositif extérieur.

2. Générateur thermique, selon la revendication 1, **caractérisé en ce que** ledit conduit (16) est de forme cylindrique.

3. Générateur thermique, selon la revendication 1, **caractérisé en ce que** ledit conduit (16) est constitué par des pores formés dans ledit moyen d'échange.

4. Générateur thermique, selon la revendication 1, **caractérisé en ce que** ledit conduit (46) est défini par des rainures.

5. Générateur thermique, selon l'une quelconque des revendications précédentes, **caractérisé en ce qu'**il comporte au moins deux circuits (11, 11') parcourus alternativement à contre-courant par le fluide extérieur dudit dispositif extérieur.

6. Générateur thermique, selon l'une quelconque des revendications précédentes, **caractérisé en ce que** ledit moyen d'échange comporte des ailettes sur sa périphérie.

7. Générateur thermique, selon l'une quelconque des revendications précédentes, **caractérisé en ce que** ledit élément magnétocalorique (2) comporte au moins deux matériaux magnétocaloriques (21, 22) disposés de manière successive et formant au moins deux étages thermiques consécutifs, reliés fluidiquement par un moyen d'entraînement (7') du fluide caloporteur commun.

8. Générateur thermique, selon l'une quelconque des revendications précédentes, **caractérisé en ce que** ledit moyen d'échange (15, 25, 35, 35', 45) est recouvert par une couche de matériau thermiquement isolant.

## Patentansprüche

1. Magnetokalorischer Wärmeerzeuger bestehend aus mehreren magnetokalorischen Elementen (2) mit jeweils einem ersten Ende (3) und einem zweiten Ende (4), einer magnetischen Anordnung, die dazu bestimmt ist, jedes magnetokalorische Element (2) einem variablen Magnetfeld auszusetzen und somit in jedem magnetokalorischen Element (2) abwechselnd einen Heiz-Zyklus und einen Kühl-Zyklus zu erzeugen, einem Antriebsmittel, um ein Wärmeübertragungsfluid abwechselnd synchron mit der Variation des Magnetfelds in Richtung von erstem Ende (3) und von zweitem Ende (4) und umgekehrt durch besagte magnetokalorische Elemente (2) zu fördern, und mindestens einem Mittel (15, 25, 35, 35', 45) um die von besagten magnetokalorischen Elementen (2) erzeugte Wärmeenergie mit einer externen Vorrichtung auszutauschen, wobei besagtes Austauschmittel in besagtem Wärmeerzeuger integriert ist, um während eines Heiz oder Kühl-Zyklusses von dem Wärmeübertragungsfluid, das an einem der Enden (3, 4) in besagte magnetokalorische Elemente (2) eintritt, in eine Richtung durchflossen zu werden, und während des anderen Kühl- oder Heiz-Zyklusses von dem Wärmeübertragungsfluid, das an selbem Ende (3, 4) aus besagten magnetokalorischen Elemente (2) austritt, in die entgegen gesetzte Richtung durchflossen zu werden, wobei besagtes Austauschmittel an zumindest einem der Enden (3, 4) von besagten magnetokalorischen Elementen (2) angrenzt und zumindest zwischen diesem Ende und besagtem Antriebsmittel (7) des Wärmeübertragungsfluids angeordnet ist, wobei besagter Erzeuger eine kreisförmige Struktur aufweist, in der besagte magnetokalorische Elemente kreisringförmig angeordnet sind, und besagtes Austauschmittel (15, 25, 35, 35', 45) die Form eines Kreisrings aufweist und mehrere Wärmeübertragungs-Zonen (8) beträgt, die jeweils gegenüber eines der magnetokalorischen Elemente (2) angeordnet sind, wobei jede Wärmeübertragungs-Zone mit Durchgängen (9) für das Wärmeübertragungsfluid und mit mindestens einem aus einer Leitung (16, 46) für ein externes Medium von besagter externen Vorrichtung bestehenden Kreislauf (11) versehen ist.

2. Wärmeerzeuger nach Anspruch 1, **dadurch gekennzeichnet, dass** besagte Leitung (16) eine zylindrische Form aufweist.

3. Wärmeerzeuger nach Anspruch 1, **dadurch gekennzeichnet, dass** besagte Leitung (16) aus Poren in besagtem Austauschmittel gebildet wird.

4. Wärmeerzeuger nach Anspruch 1, **dadurch gekennzeichnet, dass** besagte Leitung (46) durch Rillen gebildet wird.

5. Wärmeerzeuger nach einem beliebigen der vorhergehenden Ansprüche, **dadurch gekennzeichnet, dass** er zumindest zwei Kreisläufe (11, 11') beträgt, die abwechselnd gegenläufig vom externen Medium von besagter externen Vorrichtung durchflossen werden.

6. Wärmeerzeuger nach einem beliebigen der vorhergehenden Ansprüche, **dadurch gekennzeichnet, dass** besagtes Austauschmittel auf seinem Umfang mit Rippen versehen ist.

7. Wärmeerzeuger nach einem beliebigen der vorhergehenden Ansprüche, **dadurch gekennzeichnet, dass** besagtes magnetokalorisches Element (2) mindestens zwei magnetokalorische Materialien (21, 22) beträgt, die aufeinander folgend angeordnet sind und zumindest zwei aufeinander folgende Wärmestufen bilden, die über ein gemeinsames Antriebsmittel (7') des Wärmeübertragungsfluids miteinander in Fluidverbindung stehen

8. Wärmeerzeuger nach einem beliebigen der vorhergehenden Ansprüche, **dadurch gekennzeichnet, dass** besagtes Austauschmittel (15, 25, 35, 35', 45) mit einer Schicht wärmeisolierenden Materials verkleidet ist.

## Claims

1. Magnetocaloric heat generator comprising several magnetocaloric elements (2) comprising each a first end (3) and a second end (4), a magnetic arrangement intended for subjecting each magnetocaloric element (2) to a variable magnetic field, creating alternately in each magnetocaloric element (2) a heating cycle and a cooling cycle, a means for circulating a heat transfer fluid through said magnetocaloric elements (2) alternately towards the first end (3) and towards the second end (4) and vice versa, in synchronisation with the variation of the magnetic field, and at least one means of exchange (15, 25, 35, 35', 45) of the thermal energy produced by said magnetocaloric elements (2) with an external device, said exchange means being integrated in said heat generator so as to be crossed in one direction by the heat transfer fluid entering said magnetocaloric elements (2) through one of the ends (3, 4) during a heating or cooling cycle and to be crossed in the opposite direction by the heat transfer fluid exiting said magnetocaloric elements (2) through the same end (3, 4) during the other cooling or heating cycle, said exchange means being juxtaposed with at least one of the ends (3, 4) of said magnetocaloric elements (2) and arranged at least between this end and said means (7) for circulating the heat transfer fluid, said generator having a circular structure in which said magnetocaloric elements (2) are arranged on a circular ring, and said exchange means (15, 25, 35, 35', 45) having a form of a circular ring and comprises several heat transfer zones (8) arranged each in front of one of the magnetocaloric elements (2), each heat transfer zone being provided with through passages (9) for the heat transfer fluid and at least one circuit (11) made of at least one conduit (16, 46) for an external fluid belonging to said external device.

2. Heat generator according to claim 1, **characterised in that** said conduit (16) has a cylindrical shape.

3. Heat generator according to claim 1, **characterised in that** said conduit (16) is made of pores formed in said exchange means.

4. Heat generator according to claim 1, **characterised in that** said conduit (46) is defined by grooves.

5. Heat generator according to any of the previous claims, **characterised in that** it comprises at least two circuits (11, 11') in which the external fluid of said external device circulates alternately in contraflow.

6. Heat generator according to any of the previous claims, **characterised in that** said exchange means comprises fins on its periphery.

7. Heat generator according to any of the previous claims, **characterised in that** said magnetocaloric element (2) comprises at least two magnetocaloric materials (21, 22) arranged consecutively and making up at least two consecutive thermal stages in fluidic connection through a common circulation means (7') for the heat transfer fluid.

8. Heat generator according to any of the previous claims, **characterised in that** said exchange means (15, 25, 35, 35', 45) is covered with a layer of heat insulating material.
